(19) Europäisches Patentamt
European Patent Office
Office européen des brevets

(11) **EP 3 884 359 B1**

(12) **EUROPÄISCHE PATENTSCHRIFT**

(45) Veröffentlichungstag und Bekanntmachung des Hinweises auf die Patenterteilung:
**16.08.2023 Patentblatt 2023/33**

(21) Anmeldenummer: **19812937.1**

(22) Anmeldetag: **21.11.2019**

(51) Internationale Patentklassifikation (IPC):
*G06F 3/01* (2006.01)  *H01F 7/18* (2006.01)
*B60K 37/04* (2006.01)  *G01R 27/26* (2006.01)

(52) Gemeinsame Patentklassifikation (CPC):
**B60K 37/06; G01R 27/2611; G06F 3/016; H01F 7/1844;** B60K 2370/158; B60Y 2400/404; H01F 2007/185; H01F 2007/1855; H03K 2217/96062

(86) Internationale Anmeldenummer:
**PCT/EP2019/082140**

(87) Internationale Veröffentlichungsnummer:
**WO 2020/104614 (28.05.2020 Gazette 2020/22)**

(54) **VERFAHREN UND VORRICHTUNG ZUR ANSTEUERUNG EINES ZUGANKERMAGNETEN**

METHOD AND DEVICE FOR CONTROLLING A PULL-TYPE SOLENOID

PROCÉDÉ ET DISPOSITIF DE COMMANDE D'UN AIMANT À TIRANT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.11.2018 DE 102018129489**

(43) Veröffentlichungstag der Anmeldung:
**29.09.2021 Patentblatt 2021/39**

(73) Patentinhaber: **Behr-Hella Thermocontrol GmbH 59557 Lippstadt (DE)**

(72) Erfinder:
• **KIRSCH, Stefan 59557 Lippstadt (DE)**

• **BANDLOW, Bastian 59557 Lippstadt (DE)**

(74) Vertreter: **dompatent von Kreisler Selting Werner - Partnerschaft von Patent- und Rechtsanwälten mbB Deichmannhaus am Dom Bahnhofsvorplatz 1 50667 Köln (DE)**

(56) Entgegenhaltungen:
**EP-A1- 2 966 410     EP-A1- 3 141 871
GB-A- 2 256 059     JP-A- S58 221 173
US-A1- 2018 090 253**

**Beschreibung**

Die vorliegende Patentanmeldung nimmt die Priorität der deutschen Patentanmeldung 10 2018 129 489.1 vom 22. November 2018 in Anspruch.

Die Erfindung betrifft ein Verfahren und eine Vorrichtung zur Ansteuerung eines im Ruhezustand eine potentiell veränderte Luftspaltbreite aufweisenden Zugankermagneten zur Erzeugung einer vorgegebenen, vom Zugankermagnet auszuübenden Kraft zur Verwendung in einer Fahrzeug-Bedieneinheit mit haptischem Feedback. Insbesondere betrifft die Erfindung eine derartige Vorrichtung und ein derartiges Verfahren für den Einsatz bei Bedieneinheiten mit haptischem Feedback für Fahrzeuge. Ferner betrifft die Erfindung eine Fahrzeug-Bedieneinheit mit haptischem Feedback unter Verwendung des zuvor genannten Verfahrens und/oder der zuvor genannten Vorrichtung.

Zugankermagnete werden beispielsweise bei Bedieneinheiten mit haptischem Feedback eingesetzt, um ein berührungssensitives Bedienelement wie beispielsweise einen Touchscreen zur taktilen Rückmeldung einer validen Befehlseingabe pulsartig mechanisch anzuregen. Dabei sollte diese pulsartige mechanische Anregung über die Lebensdauer der Bedieneinheit möglichst konstant gleichbleibend sein.

Durch Alterungs- und Temperatureinflüsse sowie fertigungsbedingt unterliegt der im Ruhezustand eines Zugankermagneten gegebene Luftspalt Toleranzen im Bereich bis zu einigen 100 $\mu$m. Die Größe des Luftspalts geht in guter Näherung umgekehrt proportional zur Induktivität der Erregerspule des Zugankermagneten bzw. der Induktivität des Zugankermagneten ein, so dass ein und dasselbe elektrische Ansteuerungssignal, mit dem die Erregerspule beaufschlagt wird, erhebliche unterschiedliche Kraftkurven hervorruft.

In der Praxis wird die Ansteuerung von Zugankermagneten häufig durch eine Echtzeit-Regelschleife realisiert, mit deren Hilfe der Einfluss des Luftspalts ausgeglichen und dementsprechend berücksichtigt werden kann. Ein Beispiel für ein derartiges Regelsystem ist in WO-A-2017/046026 beschrieben. Aus Kosten- und Ressourcengründen (Rechenzeit, Interrupts) kommt eine Regelschleife jedoch unter Umständen nicht in Betracht.

Aus US-B-8 657 587 ist eine Infusionspumpe bekannt, bei der ein die Pumpwirkung verursachender Zugankermagnet hinsichtlich seines Luftspalts überwacht wird.

In US-A-2018/0090253 ist eine Bedieneinheit beschrieben, bei der ein Zugankermagnet verwendet wird, dessen Luftspaltbreite zur Regelung der vom Bediener auf ein Bedienelement ausgeübten Andrückkraft kompensiert wird.

Aufgabe der Erfindung ist es, ein Verfahren und eine Vorrichtung zur Ansteuerung eines Zugankermagneten zur Erzeugung einer definierten, vom Zugankermagneten aufzubringenden Kraft anzugeben, die bzw. das sensorlos und ohne Regelschleife arbeitet. Ferner ist es Aufgabe der Erfindung, eine Bedieneinheit mit einem zuvor angegebenen Verfahren bzw. einer zuvor angegebenen Vorrichtung zu schaffen.

Zur Lösung dieser Aufgabe wird mit der Erfindung eine Vorrichtung zur Ansteuerung eines im Ruhezustand eine potentiell veränderte Luftspaltbreite aufweisenden Zugankermagneten zur Erzeugung einer vorgegebenen, vom Zugankermagnet ausgeübten Kraft zur Verwendung in einer Fahrzeug-Bedieneinheit mit haptischem Feedback, vorgeschlagen, wobei die Vorrichtung versehen ist mit

- einer DC-Spannungsquelle zur Versorgung einer Erregerspule eines Zugankermagneten,
- mindestens einem parallel zur DC-Spannungsquelle geschalteten Pufferkondensator mit bekannter Kapazität,
- einem ersten Schalter, der zwischen der DC-Spannungsquelle und dem Pufferkondensator angeordnet ist,
- wobei die Erregerspule des Zugankermagneten und ein mit dieser in Reihe liegender zweiter Schalter parallel zum Pufferkondensator geschaltet sind, und
- einer Ansteuer- und Auswerteeinheit zur Ansteuerung des ersten Schalters sowie des zweiten Schalters und zur Auswertung einer über der Erregerspule abfallenden Messspannung,
- wobei die Ansteuer- und Auswerteeinheit bei aufgeladenem Pufferkondensator den ersten Schalter öffnet sowie den zweiten Schalter schließt und anhand der Messspannung die Frequenz des die Kapazität des Pufferkondensators und die Induktivität des Zugankermagneten aufweisenden Schwingkreises ermittelt,
- wobei mittels der Ansteuer- und Auswerteeinheit anhand der ermittelten Frequenz die Induktivität des Zugankermagneten ermittelbar ist,
- wobei mittels der Ansteuer- und Auswerteeinheit anhand der ermittelten Induktivität des Zugankermagneten die Luftspaltbreite des Zugankermagneten ermittelbar ist und
- wobei anhand einer Lookup-Tabelle oder einer mathematischen Modellierung des elektromagnetischen Verhaltens des Zugankermagneten von der Ansteuer- und Auswerteeinheit dasjenige PWM-Ansteuersignal an den zweiten Schalter anlegbar ist, bei dem der Zugankermagnet unter Berücksichtigung der ermittelten Luftspaltbreite zur Erzeugung einer von dem Zugankermagnet aufzubringenden vordefinierten Kraft betreibbar ist.

Ferner wird mit der Erfindung ein Verfahren zur Ansteuerung eines im Ruhezustand eine potentiell veränderte Luftspaltbreite aufweisenden Zugankermagneten zur Erzeugung einer vorgegebenen, vom Zugankermagnet ausgeübten Kraft zur Verwendung in einer Fahrzeug-Bedieneinheit mit haptischem Feedback, vorgeschlagen, mit den folgenden Schritten:

- Bereitstellen einer Lookup-Tabelle oder einer mathematischen Modellierung des elektromagnetischen Verhaltens des Zugankermagneten, wobei sich anhand der Lookup-Tabelle oder der mathematischen Modellierung ergibt, welches hinsichtlich Pulsbreite und/oder Dauer definierte PWM-Signal an eine Erregerspule des Zugankermagneten bei verschiedenen angenommenen Luftspaltbreiten zur Erzeugung einer vorgebbaren, vom Zugankermagnet aufzubringenden Kraft anzulegen ist, und
- Ermittlung der Luftspaltbreite des Zugankermagneten durch

  - Betreiben des Zugankermagneten mit parallel zur Erregerspule geschaltete Pufferkapazität als Schwingkreis,
  - Ermitteln der Schwingkreisfrequenz aus dem Spannungsabfall über der Spule bei bekannter Pufferkapazität,
  - Ermitteln der Induktivität der Erregerspule anhand der Schwingkreisfrequenz und der bekannten Pufferkapazität, und
  - Ermitteln der aktuellen Luftspaltbreite anhand der Anzahl der Wicklungen der Erregerspule und der Querschnittsfläche des Luftspalts des Zugankermagneten, und

- Ansteuerung der Erregerspule mit demjenigen PWM-Signal, das sich anhand der Lookup-Tabelle oder der mathematischen Modellierung bei Vorgabe der auszuübenden Kraft und der ermittelten Luftspaltbreite ergibt.

Schließlich dient zur Lösung der Aufgabe auch die Verwendung der zuvor genannten Vorrichtung oder des zuvor genannten Verfahrens für die Erzeugung eines haptischen Feedback bei einer Fahrzeug-Bedieneinheit.

Letztendlich wird zur Lösung der Aufgabe eine Fahrzeug-Bedieneinheit mit haptischem Feedback vorgeschlagen, die versehen ist mit

- einem Bedienelement, das manuell bedienbar ist, und
- einer Vorrichtung gemäß oben genannter Art,
- wobei der Zugankermagnet der Vorrichtung zur Erzeugung eines haptischen Feedback auf das Bedienelement mechanisch einwirkt und dieses impulsartig anregt.

Wesensmerkmal der Erfindung ist es, die Induktivität des Zugankermagneten indirekt anhand der Messspannung zu ermitteln, die über der Erregerspule des Zugankermagneten abfällt, wenn der Zugankermagnet mit einer Pufferkapazität (Pufferkondensator) als Schwingkreis betrieben wird. Aus der Messspannung kann die Frequenz des Schwingkreises ermittelt werden. Bei bekannter Pufferkapazität kann nun die Induktivität des Zugankermagneten bestimmt werden. Aus der bekannten Abhängigkeit der Induktivität von der Anzahl der Wicklungen der Erregerspule, der Größe der Querschnittsfläche des Luftspalts, der Breite des Luftspalts und der Permeabilität der Luft kann dann bei bekannter Induktivität die Luftspaltbreite errechnet werden. Mittels einer Lookup-Tabelle oder einer mathematischen Modellierung des elektromagnetischen Verhaltens des Zugankermagneten kann dann wiederum dasjenige Ansteuersignal nach Größe und Dauer ermittelt bzw. abgelesen werden, mit dem die Erregerspule anzusteuern ist, damit der Zugankermagnet eine gewünschte Kraft ausübt.

Die physikalisch-mathematischen Grundlagen und Gegebenheiten, auf denen die Erfindung letztendlich beruht, sind dabei wie folgt.

Die Induktivität eines ausreichend dimensionierten Zugankermagneten mit einem Luftspalt gehorcht in guter Näherung der Formel

$$L = \frac{N^2 A \mu_0}{h}$$

Dabei ist N die Anzahl der Wicklungen der Spule, A die Querschnittsfläche des Luftspalts, h seine Länge und $\mu_0$ die Permeabilität der Luft. Während alle übrigen Parameter relativ genau feststehen und nur unwesentlich schwanken, unterliegt die Länge des Luftspalts h größeren Toleranzen und äußeren Einflüssen.

Naheliegend wäre es nun, die Länge des Luftspalts mittels geeigneter Sensorik zu messen und ihren Einfluss auf die Induktivität durch Regelung zu kompensieren. Alternativ gibt es Konzepte, bei denen mit Hilfe einer zusätzlichen Messspule der magnetische Fluss im Kern des Magneten gemessen und basierend darauf geregelt wird (siehe z.B. WO 2017/046026 A1).

Zur Reduzierung des Hardware-Aufwands wird erfindungsgemäß vorgeschlagen, die Induktivität der Anordnung indirekt zu messen und daraus gemäß obiger Formel Rückschlüsse auf die Luftspaltbreite zu ziehen. Dies sollte nicht im Kontext einer Regelung erfolgen, sondern zu einigen wenigen, aus Endanwendersicht geeignet gewählten Zeitpunkten, wie z.B., nachdem eine nennenswerte Temperaturänderung eingetreten ist, aufgrund derer sich vermuten lässt, dass sich der Luftspalt geändert hat. Zudem sollte in jedem Fall eine Initialmessung beim Start des Geräts durchgeführt werden.

Erfindungsgemäß ist die Messung so realisiert, dass die Spule des Zugankermagneten über einen Schalter mit einer ohnehin vorhandenen, geladenen Pufferkapazität C verbunden wird. Gleichzeitig werden die Pufferkondensatoren von der Spannungsquelle getrennt. Gegebenenfalls müssen noch Maßnahmen (z.B. zuschaltbare Widerstände) ergriffen werden, damit der Strom nicht so hoch wird, dass eine signifikante Luftspaltänderung eintritt. So entsteht ein elektrischer (RLC-)Schwingkreis, dessen Resonanzfrequenz $f$ sich zu

$$f = \frac{1}{2\pi}\sqrt{\frac{1}{LC}}$$

ergibt.

Über einen vorzugsweise hochohmigen A/D Wandler kann die Spannung des Schwingkreises gemessen und hinsichtlich ihrer Frequenz softwareseitig ausgewertet werden. Um die erforderliche Samplerate und Rechenleistung des Microcontrollers der Ansteuer- und Auswerteeinheit beschränkt zu halten, bietet es sich an, die Kapazität C so zu wählen, dass die Frequenz gemäß der angegebenen Formel niedrig ist. Aus dieser Messung folgt dann mit bekannter Kapazität und der gemessenen Frequenz für die Induktivität

$$L = \frac{1}{C(2\pi f)^2}$$

und schließlich für die Luftspaltbreite

$$h = \frac{N^2 A \mu_0}{L}$$

Anhand der so ermittelten Luftspaltbreite können aus mathematischen Modellen oder Lookup-Tabellen die passenden elektrischen Ansteuerungssignale ermittelt werden, um ein definiertes Kraftprofil ohne Regelung zu erzeugen.

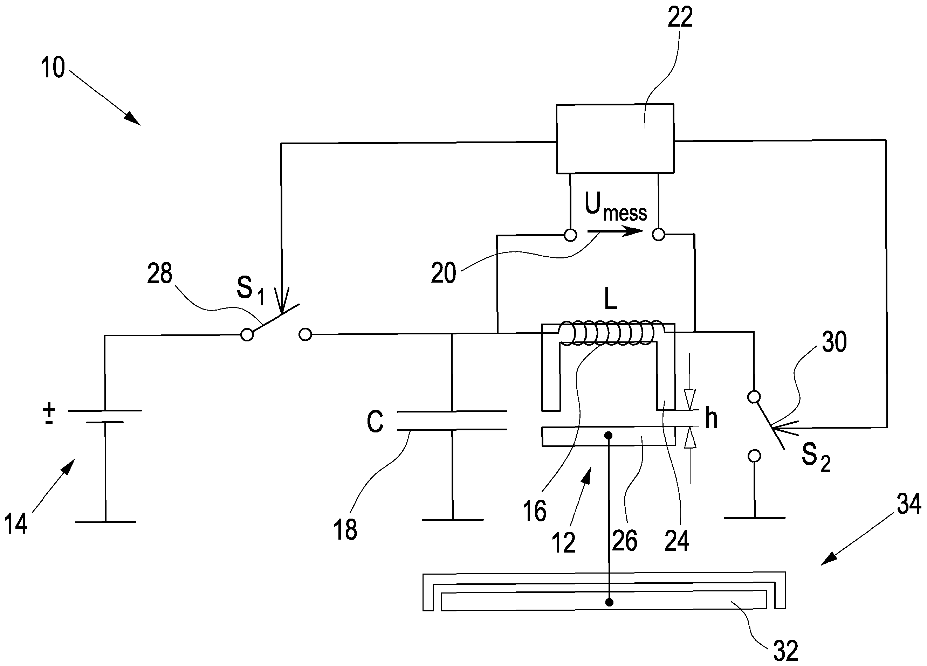

Die Erfindung wird nachfolgend anhand der Zeichnung, in der eine Prinzip-Schaltskizze dargestellt ist, näher erläutert.

Die Schaltung 10 zur Ansteuerung eines Zugankermagneten 12 weist eine DC-Spannungsquelle 14 zur Speisung der Erregerspule 16 des Zugankermagneten auf. Parallel zur DC-Spannungsquelle 14 ist ein Pufferkondensator 18 geschaltet. Über der Erregerspule 16 fällt die Messspannung 20 ab, die von einer Auswerte- und Ansteuereinheit 22 ausgewertet wird. Bei der Auswerte- und Ansteuereinheit 22 handelt es sich um eine Vorrichtung mit beispielsweise einem Microcontroller, einem A/D-Wandler und weiteren für die digitale Signalverarbeitung erforderlichen Komponenten, was grundsätzlich bekannt ist.

Mit h ist die Luftspaltbreite zwischen dem Joch 24 und dem Zuganker 26 des Zugankermagneten 12 bezeichnet. Der Zuganker 26 ist mechanisch gekoppelt mit einem Bedienelement einer beispielsweise Fahrzeug-Bedieneinheit. Das Bedienelement weist eine beispielsweise berührungsempfindliche Bedienoberfläche auf. Bei valider Betätigung des Bedienelements wird dieses mechanisch angeregt, um eine taktile Rückmeldung zu gegen. Hierzu wird ein insbesondere Halbleiter-Schalter 28 mit einem von der Auswerte- und Ansteuereinheit 22 erzeugten Ansteuersignal für eine bestimmte Zeitdauer geschlossen.

Um nun auch bei beispielsweise temperaturbedingter Änderung der Luftspaltbreite h die Erregerspule 16 durch Schließen des Schalters 28 mit der für die gewünschte Krafterzeugung erforderlichen elektrischen Energie zu versorgen, bedarf es von Zeit zu Zeit der Ermittlung der Luftspaltbreite h. Hierzu wird der Schalter 28 geöffnet und ein weiterer Schalter, insbesondere ein Halbleiter-Schalter 30 geschlossen, der zuvor geöffnet war. Bei geschlossenem Schalter 30 wird die Messspannung 20 ausgewertet, um die Frequenz des Schwingkreises aus der Pufferkapazität C und der Induktivität L des Zugankermagneten 12 zu bestimmten. Bei bekannter Pufferkapazität C kann damit die Induktivität L des Zugankermagneten 12 ermittelt werden und daraus wiederum bei bekannter Wicklungsanzahl der Erregerspule 16 und bekannter Querschnittsfläche A des Luftspalts die Luftspaltbreite h berechnet werden. In einer beispielsweise Lookup-Tabelle oder durch Modellierung des Zugankermagneten 12 kann dann die Pulsdauer ermittelt werden, für die der Schalter 28 geschlossen werden muss, um bei der aktuell ermittelten Luftspaltbreite h die erforderliche bzw. gewünschte Kraft durch den Zugankermagneten 12 zu erzeugen.

Der wesentliche Vorteil der Schaltung 10 bzw. der erfindungsgemäßen Vorrichtung besteht darin, dass ohne Regelschleife und sensorlos der Zugankermagnet angesteuert werden kann, um die gewünschte Kraft aufzubringen. Damit bedarf es im Gegensatz zu bekannten Zugankermagnet-Ansteuerung von insbesondere Bedienelementen mit haptischem Feedback für Fahrzeug keiner teuren und rechenintensiven Echtzeit-Regelschleife, indem die Steuerung des Zugankermagneten basierend auf der indirekten Vermessung der Luftspaltbreite erfolgt.

In der Zeichnung ist mit dem Bezugszeichen 32 ein Bedienelement einer Fahrzeug-Bedieneinheit 34 angedeutet, das von dem Zugankermagnet 12 impulsartig mechanisch angeregt wird, um ein haptisches Feedback zu erzeugen. Bei dem Bedienelement 32 kann es sich um einen Touchscreen oder ein Touchpad handeln. Bei Erkennung einer validen Bedienung des Bedienelements 32 wird der Zugankermagnet 12 angesteuert, um dem Bediener taktil die valide Bedienung zu signalisieren.

**BEZUGSZEICHENLISTE**

| | |
|---|---|
| 10 | Schaltung |
| 12 | Zugankermagnet |
| 14 | DC-Spannungsquelle |
| 16 | Erregerspule |
| 18 | Pufferkondensator |
| 20 | Messspannung |
| 22 | Auswerte- und Ansteuereinheit |
| 24 | Joch |

26 Zuganker
28 Halbleiter-Schalter
30 Halbleiter-Schalter
32 Bedienelement
34 Bedieneinheit
A Querschnittsfläche
C Pufferkapazität
L Induktivität
h Luftspaltbreite

**Patentansprüche**

1. Vorrichtung zur Ansteuerung eines im Ruhezustand eine potentiell veränderte Luftspaltbreite aufweisenden Zugankermagneten zur Erzeugung einer vorgegebenen, vom Zugankermagnet ausgeübten Kraft zur Verwendung in einer Fahrzeug-Bedieneinheit mit haptischem Feedback, mit

   - einer DC-Spannungsquelle (14) zur Versorgung einer Erregerspule (16) eines Zugankermagneten (12),
   - mindestens einem parallel zur DC-Spannungsquelle (14) geschalteten Pufferkondensator (18) mit bekannter Kapazität (C),
   - einem ersten Schalter (28), der zwischen der DC-Spannungsquelle (14) und dem Pufferkondensator (18) angeordnet ist,
   - wobei die Erregerspule (16) des Zugankermagneten (12) und ein mit dieser in Reihe liegender zweiter Schalter (30) parallel zum Pufferkondensator (18) geschaltet sind, und
   - einer Ansteuer- und Auswerteeinheit (22) zur Ansteuerung des ersten Schalters (28) sowie des zweiten Schalters (30) und zur Auswertung einer über der Erregerspule (16) abfallenden Messspannung (20),
   - wobei die Ansteuer- und Auswerteeinheit (22) bei aufgeladenem Pufferkondensator (18) den ersten Schalter (28) öffnet sowie den zweiten Schalter (30) schließt und anhand der Messspannung (20) die Frequenz des die Kapazität (C) des Pufferkondensators (18) und die Induktivität (L) des Zugankermagneten (12) aufweisenden Schwingkreises ermittelt,
   - wobei mittels der Ansteuer- und Auswerteeinheit (22) anhand der ermittelten Frequenz die Induktivität (L) des Zugankermagneten (12) ermittelbar ist,
   - wobei mittels der Ansteuer- und Auswerteeinheit (22) anhand der ermittelten Induktivität (L) des Zugankermagneten (12) die Luftspaltbreite (h) des Zugankermagneten (12) ermittelbar ist und
   - wobei anhand einer Lookup-Tabelle oder einer mathematischen Modellierung des elektromagnetischen Verhaltens des Zugankermagneten (12) von der Ansteuer- und Auswerteeinheit (22) dasjenige PWM-Ansteuersignal an den zweiten Schalter (30) anlegbar ist, bei dem der Zugankermagnet (12) unter Berücksichtigung der ermittelten Luftspaltbreite (h) zur Erzeugung einer von dem Zugankermagnet (12) aufzubringenden vordefinierten Kraft betreibbar ist.

2. Verfahren zur Ansteuerung eines im Ruhezustand eine potentiell veränderte Luftspaltbreite aufweisenden Zugankermagneten zur Erzeugung einer vorgegebenen, vom Zugankermagnet ausgeübten Kraft zur Verwendung in einer Fahrzeug-Bedieneinheit mit haptischem Feedback, mit den folgenden Schritten

   - Bereitstellen einer Lookup-Tabelle oder einer mathematischen Modellierung des elektromagnetischen Verhaltens des Zugankermagneten (12), wobei sich anhand der Lookup-Tabelle oder der mathematischen Modellierung ergibt, welches hinsichtlich Pulsbreite und/oder Dauer definierte PWM-Signal an eine Erregerspule (16) des Zugankermagneten (12) bei verschiedenen angenommenen Luftspaltbreiten (h) zur Erzeugung einer vorgebbaren, vom Zugankermagnet (12) aufzubringenden Kraft anzulegen ist, und
   - Ermittlung der Luftspaltbreite (h) des Zugankermagneten (12) durch

     - Betreiben des Zugankermagneten (12) mit parallel zur Erregerspule (16) geschaltete Pufferkapazität (C) als Schwingkreis,
     - Ermitteln der Schwingkreisfrequenz aus dem Spannungsabfall über der Spule (16) bei bekannter Pufferkapazität (C),
     - Ermitteln der Induktivität (L) der Erregerspule (16) anhand der Schwingkreisfrequenz und der bekannten Pufferkapazität (C), und
     - Ermitteln der aktuellen Luftspaltbreite (h) anhand der Anzahl der Wicklungen der Erregerspule (16) und der Querschnittsfläche (A) des Luftspalts des Zugankermagneten (12), und

   - Ansteuerung der Erregerspule (16) mit demjenigen PWM-Signal, das sich anhand der Lookup-Tabelle oder der mathematischen Modellierung bei Vorgabe der auszuübenden Kraft und der ermittelten Luftspaltbreite (h) ergibt.

3. Verwendung der Vorrichtung nach Anspruch 1 oder des Verfahrens nach Anspruch 2 für die Erzeugung eines haptischen Feedback bei einer Fahrzeug-Bedieneinheit.

**4.** Fahrzeug-Bedieneinheit mit haptischem Feedback, mit

- einem Bedienelement (32), das manuell bedienbar ist, und
- einer Vorrichtung (10) nach Anspruch 1,
- wobei der Zugankermagnet (12) der Vorrichtung (10) zur Erzeugung eines haptischen Feedback auf das Bedienelement (32) mechanisch einwirkt und dieses impulsartig anregt.

**Claims**

**1.** A device for controlling an armature solenoid for generating a predefined force to be exerted by the armature solenoid for use in a vehicle operating unit with haptic feedback, which armature solenoid has a potentially changed air gap width in an idle state, wherein the device is provided with

- a DC voltage source (14) for supplying an exciter coil (16) of an armature solenoid (12),
- at least one buffer capacitor (18) connected in parallel to the DC voltage source (14) and having a known capacitance (C),
- a first switch (28) arranged between the DC voltage source (14) and the buffer capacitor (18),
- the exciter coil (16) of the armature solenoid (12) and a second switch (30) arranged in series therewith being connected in parallel to the buffer capacitor (18), and
- a control and evaluation unit (22) for controlling the first switch (28), as well as the second switch (30) and for evaluating a measurement voltage (20) dropping over the exciter coil (16),
- the control and evaluation unit (22), when the buffer capacitor (18) is in a charged state, opening the first switch (28) and closing the second switch (30) and determining, from the measurement voltage (20), the frequency of the resonant circuit having the capacitance (C) of the buffer capacitor (18) and the inductance (L) of the armature solenoid (12),
- the inductance (L) of the armature solenoid (12) being determinable by the control and evaluation unit (22) based on the determined frequency,
- the air gap width (h) of the armature solenoid (12) being determinable by the control and evaluation unit (22) based on the determined inductance (L) of the armature solenoid (12),
- on the basis of a look-up table or a mathematical modelling of the electromagnetic behavior of the armature solenoid (12), the control and evaluation unit (22) can apply to the second switch (30) the PWM control signal with which, with consideration to the air gap width (h) determined, the armature solenoid (12) is operable to generate a predefined force to be applied by the armature solenoid (12).

**2.** A method for controlling an armature solenoid for generating a predefined force to be exerted by the armature solenoid for use in a vehicle operating unit with haptic feedback, which solenoid has a potentially changed air gap width in an idle state, the method comprising the following steps:

- providing a look-up table or a mathematical modelling of the electromagnetic behavior of the armature solenoid (12), wherein it results from the look-up table or the mathematical modelling which PWM signal defined with respect to pulse width and/or duration is to be applied to an exciter coil (16) of the armature solenoid (12) for different assumed air gap widths (h) in order to generate a predefinable force to be applied by the armature solenoid (12), and
- determining the air gap width (h) of the armature solenoid (12) by

- operating the armature solenoid (12) as a resonant circuit with a buffer capacitance (C) connected in parallel to the exciter coil (16),
- determining the resonant circuit frequency from the voltage drop over the exciter coil (16), with the buffer capacitance (C) being known,
- determining the inductance (L) of the exciter coil (16) based on the resonant circuit frequency and the known buffer capacitance (C), and
- determining the current air gap width (h) based on the number of windings of the exciter coil (16) and the cross sectional area (A) of the air gap of the armature solenoid (12), and

- controlling the exciter coil (16) by the PWM signal which is obtained based on the look-up table or the mathematical modelling, with the force to be exerted and the determined air gap width (h) being given.

**3.** The use of the device of claim 1 or of the method of claim 2 for generating a haptic feedback in a vehicle operating unit.

**4.** A vehicle operating unit with haptic feedback, comprising:

- an operating element (32) which is manually operable, and

- a device (10) of the type mentioned above,
- the armature solenoid (12) of the device (10) acting mechanically on the operating element (32) and exciting the same in a pulse-like manner to generate a haptic feedback.

## Revendications

1. Dispositif de pilotage d'un aimant à tirant comportant au repos une largeur d'entrefer potentiellement modifiée afin de générer une force prédéfinie exercée par l'aimant à tirant pour utilisation dans une unité de commande de véhicule à rétroaction haptique, doté

   - d'une source de tension en courant continu (14) pour l'alimentation d'une bobine excitatrice (16) d'un aimant à tirant (12),
   - d'au moins un condensateur tampon (18) de capacité (C) connue, commuté en parallèle par rapport à la source de tension en courant continu (14),
   - d'un premier commutateur (28) disposé entre la source de tension en courant continu (14) et le condensateur tampon (18),
   - dans lequel la bobine excitatrice (16) de l'aimant à tirant (12) et un deuxième commutateur (30) branché en série par rapport à celle-ci sont commutés en parallèle par rapport au condensateur tampon (18), et
   - d'une unité de contrôle et de pilotage (22) destinée à piloter le premier commutateur (28) ainsi que le deuxième commutateur (30) et à contrôler une chute de tension de mesure (20) causée par la bobine excitatrice (16),
   - dans lequel l'unité de contrôle et de pilotage (22) ouvre le premier commutateur (28) et ferme le deuxième commutateur (30) lorsque le condensateur tampon (18) est chargé et détermine à l'aide de la tension de mesure (20) la fréquence du circuit résonant comportant la capacité (C) du condensateur tampon (18) et l'inductance (L) de l'aimant à tirant (12),
   - dans lequel l'inductance (L) de l'aimant à tirant (12) peut, à l'aide de la fréquence déterminée, être déterminée au moyen de l'unité de contrôle et de pilotage (22),
   - dans lequel la largeur d'entrefer (h) de l'aimant à tirant (12) peut, à l'aide de l'inductance (L) de l'aimant à tirant (12) déterminée, être déterminée au moyen de l'unité de contrôle et de pilotage (22) et
   - dans lequel à l'aide d'une table de correspondance ou d'une modélisation mathématique du comportement électromagnétique de l'aimant à tirant (12) par l'unité de contrôle et de pilotage (22), le signal de commande PWM peut être appliqué lors duquel l'aimant à tirant (12) est utilisable pour générer une force prédéfinie à exercer par l'aimant à tirant (12) en prenant en compte la largeur d'entrefer (h) déterminée.

2. Procédé de pilotage d'un aimant à tirant comportant à l'état de repos une largeur d'entrefer potentiellement modifiée afin de générer une force prédéfinie exercée par l'aimant à tirant pour utilisation dans une unité de commande de véhicule à rétroaction haptique, avec les étapes suivantes

   - préparation d'une table de correspondance ou d'une modélisation mathématique du comportement électromagnétique de l'aimant à tirant (12), dans lequel la table de correspondance ou la modélisation mathématique indique quel signal PWM défini en termes de largeur d'impulsion et/ou de durée doit être appliqué à la bobine excitatrice (16) de l'aimant à tirant (12) pour différentes largeurs acquises d'entrefer (h) afin de générer une force prédéfinissable à exercer par l'aimant à tirant (12), et
   - détermination de la largeur d'entrefer (h) de l'aimant à tirant (12) par

      - utilisation de l'aimant à tirant (12) avec la capacité tampon (C) commutée en parallèle par rapport à la bobine excitatrice (16) en tant que circuit résonant,
      - détermination de la fréquence du circuit résonant à partir de la chute de tension aux bornes de la bobine (16) pour une capacité tampon connue (C),
      - détermination de l'inductance (L) de la bobine excitatrice (16) à l'aide de la fréquence du circuit résonant et de la capacité tampon connue (C),
      - détermination de la largeur d'entrefer (h) actuelle à l'aide du nombre d'enroulements de la bobine excitatrice (16) et de la section transversale (A) de l'entrefer de l'aimant à tirant (12), et

   - pilotage de la bobine excitatrice (16) avec le signal PWM indiqué par la table de correspondance ou la modélisation mathématique en fonction de la force à exercer et de la largeur d'entrefer (h) déterminée.

3. Utilisation du dispositif selon la revendication 1 ou du procédé selon la revendication 2 pour générer une rétroaction haptique sur une unité de commande de véhicule.

4. Unité de commande de véhicule dotée de rétroaction haptique, dotée

- d'un élément de commande (32) manuellement commandable, et
- d'un dispositif (10) selon la revendication 1,
- dans laquelle l'aimant à tirant (12) du dispositif (10) opère mécaniquement sur l'élément de commande (32) et excite celui-ci par impulsions afin de générer une rétroaction haptique.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102018129489
- WO 2017046026 A
- US 8657587 B
- US 20180090253 A
- WO 2017046026 A1